# FASCICULE DE BREVET EUROPEEN

(11) **EP 3 680 677 B1**
(45) Date de publication et mention de la délivrance du brevet: **03.03.2021**
(21) Numéro de dépôt: 19218100.6
(22) Date de dépôt: 19.12.2019
(51) Int. Cl.: G01R 31/54, G01R 31/58, G01R 35/00, G01R 27/02

(54) **PROCÉDÉ DE CONTRÔLE D'UNE PINCE D'UN APPAREIL DE MESURE DE CONDUCTIVITÉ ÉLECTRIQUE DE BOUCLE**
VERFAHREN DER KONTROLLE EINER ZANGE EINES GERÄTS ZUR MESSUNG DER ELEKTRISCHEN SCHLEIFENLEITFÄHIGKEIT
METHOD FOR CONTROLLING A CLAMP OF A DEVICE FOR MEASURING ELECTRICAL CONDUCTIVITY OF A LOOP

(30) Priorité: 10.01.2019 FR 1900240
(43) Date de publication de la demande: 15.07.2020
(73) Titulaire: ATEQ, 78340 Les Clayes-sous-Bois (FR)
(72) Inventeur: PHILIPPE, Kevin, 78340 Les Clayes-sous-Bois (FR); LAIGNEAU, David, 78340 Les Clayes-sous-Bois (FR); PLATEAU, Olivier, 78340 Les Clayes-sous-Bois (FR)
(74) Mandataire: Vidon Brevets & Stratégie

(56) Documents cités:
- EP-A1- 2 385 382
- FR-A1- 2 774 772
- US-A- 5 481 198

## Description

### 1. Domaine technique

La présente invention concerne les appareils de mesure d'une conductivité électrique d'une boucle dans un réseau conducteur électriquement mettant en œuvre une pince de couplage à la boucle.

L'invention trouve notamment son application dans le domaine aéronautique en vue de la détection d'une rupture de continuité électrique d'un réseau conducteur électriquement (par exemple métallique), c'est-à-dire la variation de la conductivité électrique (ou de la résistance) d'une ou plusieurs parties dudit réseau.

### 2. Art Antérieur

Il est connu, et rappelé ici de façon simplifiée, qu'un appareil de mesure d'une résistance électrique, ou ohmmètre, d'un réseau conducteur électriquement permet de mesurer la valeur de la résistance au niveau d'une jonction entre deux éléments métalliques constitutifs du réseau conducteur électriquement et/ou de mesurer la valeur de la résistance dans une boucle métallique formée par une succession d'éléments métalliques constitutifs du réseau conducteur électriquement.

Un tel appareil de mesure permet notamment de s'assurer que les éléments constitutifs d'un réseau conducteur électriquement sont correctement connectés et/ou assemblés entre eux, c'est-à-dire que ledit réseau ne présente pas de discontinuité électrique.

L'utilisation d'un tel appareil de mesure trouve des applications dans de nombreux domaines, tels que l'automobile, l'aéronautique, et l'aérospatial.

Par exemple, dans un aéronef, l'alimentation électrique de ses différents équipements électriques, tels les commandes de vol, divers capteurs, et les sièges, est assurée par un circuit d'alimentation en courant électrique.

On connaît aussi du document FR 2 774 772 un procédé de mesure de la résistance d'un circuit électrique inconnu connecté à des moyens de détection de sa tension. Dans ce procédé, on génère un signal électrique de référence aux caractéristiques connues, puis on transmet ce signal électrique de référence au circuit inconnu par induction électromagnétique, puis on recueille, par induction électromagnétique, un signal électrique modifié correspondant au signal de référence modifié par le circuit inconnu, puis on compare les signaux électriques de référence et modifié, et enfin on en déduit la résistance du circuit inconnu. L'invention concerne également un dispositif de détection de la tension et de mesure de la résistance d'un circuit électrique inconnu.

Pour connecter les équipements à la masse métallique d'un aéronef dont la carlingue est réalisée en matériau composite (qui est moins bon conducteur du courant électrique que le métal), et ainsi assurer le retour de courant, il est connu d'utiliser un réseau d'éléments structurels métalliques, au niveau du fuselage, désigné par le terme réseau électrique de structure ou en anglais "electrical structural network" ou ESN.

Dans la plupart des cas, il s'agit simplement d'effectuer une mesure de routine ou un contrôle rapide sans qu'il soit indispensable de connaitre, avec précision, la valeur de la résistance. Ainsi, lorsqu'il s'agit de mesurer la continuité électrique, ou conductivité, du réseau ESN d'un aéronef, l'opérateur doit simplement savoir si la résistance est au-dessus ou en-dessous d'une certaine valeur seuil, cette dernière étant caractéristique de la continuité du réseau. Pour ce faire, l'appareil de mesure est configuré pour émettre un signal visuel et/ou sonore, par exemple, en cas de dépassement de ladite valeur seuil représentatif d'une conductivité satisfaisante.

De façon classique, l'appareil de mesure met en œuvre au moins une pince qui vient enserrer un des éléments conducteurs appartenant à la boucle faisant l'objet d'une mesure de continuité.

La pince est reliée à un générateur délivrant un courant électrique qui est transmis par induction électromagnétique de la pince vers la boucle. La même pince recueille le courant électrique circulant dans la boucle par induction électromagnétique, ce qui permet à l'appareil de déterminer la valeur d'une grandeur physique, telle que la résistance électrique, de la boucle représentative de la continuité électrique de la boucle.

Toutefois, l'utilisation répétée de l'appareil de mesure provoque une usure de la pince. Une telle usure se traduit par l'incapacité pour la pince d'injecter l'intensité de courant voulu, généralement délivré par le générateur. De ce fait, l'intensité du courant injecté étant différent de celle attendue, la valeur de la résistance calculée est erronée.

De telles erreurs de mesure sont problématiques, car une valeur de résistance erronée peut être assimilée, par l'utilisateur de l'appareil ou l'opérateur, soit à un défaut de continuité électrique du réseau conducteur, ce qui peut engendrer des opérations inutiles de maintenance, soit à une mesure de continuité correcte alors que ce n'est pas le cas.

Il existe donc un besoin de fournir une solution qui permette de contrôler l'état d'usure d'une pince d'un tel appareil de mesure et plus généralement la précision d'un tel appareil.

Il existe également un besoin pour une telle solution pouvant être fabriquée aisément et à moindre coût.

Il existe en outre un besoin pour une telle technique qui soit peu encombrante et permette une intégration simplifiée notamment dans des appareils de mesure préexistants.

### 3. Résumé de l'invention

L'invention a pour objectif de proposer une solution palliant au moins certains des inconvénients de l'art antérieur cité ci-dessus.

Pour cela, l'invention concerne un procédé de contrôle d'une pince d'un appareil de mesure de conductivité électrique de boucle, ledit appareil de mesure étant configuré pour induire un courant électrique dans la boucle par le biais de ladite pince, et pour obtenir la valeur du courant circulant dans la boucle de sorte à déterminer la conductivité électrique de ladite boucle, ledit procédé comprenant les étapes suivantes:
- lors d'une utilisation de ladite pince, alimentation de ladite pince avec un signal électrique de test délivré par ledit appareil de mesure, puis mesure, au niveau de ladite pince, d'une valeur d'intensité du signal électrique de test, et
- comparaison entre la valeur mesurée d'intensité du signal électrique de test et une valeur d'intensité de référence, et, si la différence entre lesdites valeurs comparées est supérieure à un seuil prédéterminé, détection d'une usure de ladite pince.

L'invention propose une méthode de test permettant de contrôler les caractéristiques (capacité d'injection de courant) de la pince d'un appareil de mesure de conductivité électrique de boucle.

Un tel procédé de contrôle peut, par exemple, être initié à chaque utilisation de la pince, après un certain nombre d'utilisations de la pince, ou selon la volonté de l'utilisateur. Quelque soit la fréquence d'initiation du procédé de contrôle, l'état de la pince est contrôlé pour déterminer une éventuelle usure de celle-ci auquel cas les mesures effectuées par l'appareil ne sont plus fiables. S'il est déterminé que la pince est défaillante ou usée, l'utilisateur peut choisir d'utiliser une autre pince qui sera testée selon le même principe.

Un tel contrôle permet d'améliorer la fiabilité des calculs de conductivité électrique de boucle par l'appareil. Un tel procédé de contrôle peut aisément être implémenté dans un appareil de mesure muni d'une pince présentant un unique enroulement d'injection et de mesure, sans nécessiter l'ajout d'éléments complémentaires, ni la modification des éléments existants.

Une telle solution de contrôle de l'usure de la pince est donc relativement simple et peu coûteuse à mettre en œuvre.

Selon un mode de réalisation de l'invention, le procédé de contrôle comprend en outre, lors de ladite utilisation de ladite pince, une étape de lecture par ledit appareil de mesure de données d'identification de ladite pince mémorisées dans une mémoire de stockage de ladite pince, et une étape d'enregistrement desdites données d'identification lues et de la valeur mesurée d'intensité du signal électrique de test dans une mémoire de stockage dudit appareil de mesure.

Ainsi, par le biais de la mise en œuvre de données d'identification associées à la pince, il est relativement aisé de déterminer si la pince qui est couplée à l'appareil de mesure est utilisée pour la première fois ou, au contraire, si elle a déjà utilisée avec l'appareil.

Selon un mode de réalisation de l'invention, le procédé de contrôle comprend une étape de lecture dans ladite mémoire de stockage de ladite pince de la valeur d'intensité de référence.

Selon un mode de réalisation de l'invention, le procédé de contrôle comprend, préalablement à une première utilisation de ladite pince, une étape d'étalonnage de la pince en alimentant la pince avec un signal électrique de référence de sorte à obtenir au moins une valeur d'intensité de référence de la pince.

Selon un mode de réalisation de l'invention, le procédé de contrôle comprend une étape de mémorisation d'au moins ladite valeur d'intensité de référence dans ladite mémoire de stockage de ladite pince.

Selon un mode de réalisation particulier de l'invention, l'étape d'étalonnage consiste à alimenter la pince avec un signal électrique de référence variable de sorte à obtenir une table de référence en tension, intensité et fréquence caractéristique de ladite pince.

Selon un mode de réalisation de l'invention, le procédé de contrôle comprend en outre une étape de signalisation sonore et/ou visuelle, par ledit appareil de mesure, d'une usure de ladite pince.

Ainsi, l'utilisateur est alerté de façon efficace et simple lorsque la pince couplée à l'appareil de mesure est usée. L'utilisateur peut ainsi procéder à la vérification et/ou au remplacement de cette pince.

Selon un mode de réalisation de l'invention, ledit seuil prédéterminé est compris entre 10 et 60% de ladite valeur d'intensité de référence.

Un seuil de comparaison situé dans un tel intervalle permet de détecter efficacement une pince usée tout en évitant d'assimiler une pince en bon état, dont la valeur d'intensité mesurée dériverait légèrement de la valeur d'intensité de référence, à une pince usée.

L'invention concerne également un appareil de mesure de conductivité électrique de boucle configuré pour induire un courant électrique dans la boucle par le biais d'une pince, et pour obtenir, par le biais de ladite pince, la valeur du courant circulant dans la boucle de sorte à déterminer la conductivité électrique de ladite boucle, ledit appareil de mesure comprenant :
- des moyens d'alimentation de ladite pince avec un signal électrique de test lors d'une utilisation de ladite pince,
- des moyens de mesure, au niveau de ladite pince, d'une valeur d'intensité du signal électrique de test,
- des moyens de comparaison entre la valeur mesurée d'intensité du signal électrique de test, et une valeur d'intensité de référence,
- des moyens de détection d'une usure de ladite pince lorsque la différence calculée entre lesdites valeurs comparées est supérieure à un seuil prédéterminé.

Préférentiellement un tel appareil de mesure de conductivité électrique de boucle est configuré pour contrôler le niveau d'usure de la pince qui est raccordée audit appareil. Ceci permet d'assurer une mesure de conductivité électrique de boucle fiable.

Selon un mode de réalisation de l'invention, ladite pince comprend une mémoire de stockage d'une valeur d'intensité de référence, ladite valeur étant destinée à être lue par ledit appareil de mesure pour détecter une usure éventuelle de ladite pince.

Selon un autre mode de réalisation de l'invention, ladite mémoire de stockage de ladite pince stocke en outre au moins une des informations suivantes :
- des données d'identification de ladite pince ;
- un indicateur d'usure de ladite pince ;
- un nombre d'utilisations de ladite pince ;
- une valeur de déphasage de référence entre un courant d'étalonnage injecté dans ladite pince et un courant délivré par la pince;
- le nombre de spires de la pince ;
- un coefficient d'un câble de la pince permettant de relier la pince audit appareil de mesure.

### 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :
[Fig. 1] est une coupe transversale d'un aéronef dans lequel peut être utilisé un appareil de mesure conforme à l'invention ;
[Fig. 2] est un schéma fonctionnel d'un appareil de mesure de résistance de boucle configuré pour mettre en œuvre le procédé de contrôle conforme à la technique proposée
[Fig. 3] est un logigramme illustrant les étapes principales d'utilisation de l'appareil de mesure de résistance de boucle illustré en [Fig. 2] ; et
[Fig. 4] est un logigramme détaillant un mode de réalisation des étapes de contrôle de la pince de l'appareil de [Fig. 3] .

### 5. Exposé de l'invention

### Contexte

Pour faciliter la compréhension de l'invention, celle-ci est décrite, à titre d'exemple non-limitatif, lorsqu'elle est mise en œuvre dans un appareil destiné à mesurer la conductivité électrique de boucle d'une structure de retour de courant ESN d'un aéronef.

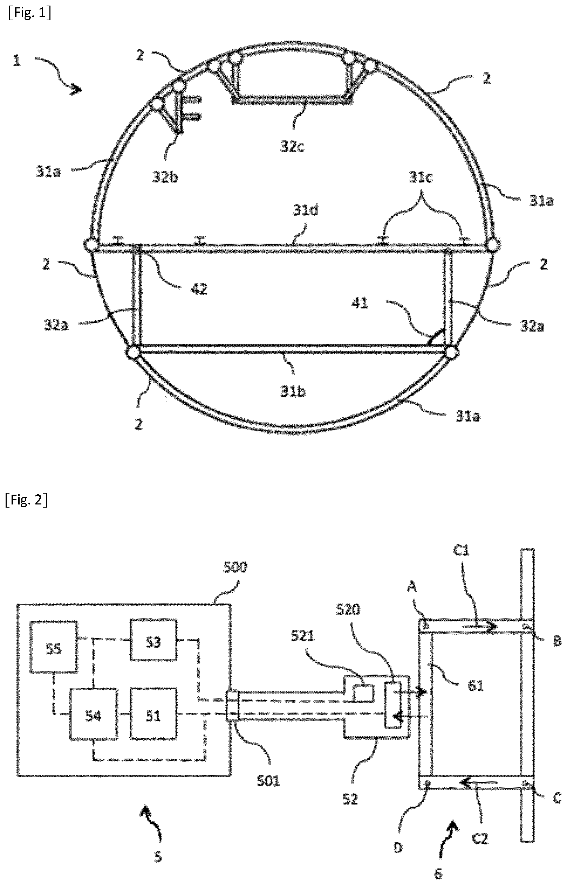

La figure 1, qui est une coupe transversale d'un aéronef, illustre un réseau de retour de courant de type ESN.

L'aéronef 1 comprend une enveloppe extérieure formée par des panneaux 2 réalisés en matériau composite, tel que le carbone ou des alliages de résines et de fibres. L'utilisation de tels panneaux permet d'alléger la masse et d'améliorer la résistance de l'aéronef. Toutefois, la conductivité électrique de tels panneaux composites 2 est relativement faible ce qui empêche ceux-ci d'être utilisés pour définir le réseau de retour de courant.

Dans une telle situation, le réseau de retour de courant est réalisé par le biais d'un réseau ESN situé dans la zone pressurisée de l'enveloppe extérieure.

Dans le réseau ESN d'un aéronef, chaque élément est métallique et est relié à au moins deux autres éléments. En d'autres termes, le réseau ESN est un réseau maillé et redondé et ce, afin de respecter certaines normes de sécurité, notamment celles édictées par les instances de l'aviation civile.

Plus précisément, le réseau ESN comprend des éléments structurels 3 et des éléments de jonction 4 qui assurent la continuité électrique entre divers éléments structurels 3.

Les éléments structurels 3 du réseau ESN se déclinent en deux catégories, à savoir :
- les éléments structurels primaires 31, tels que les cadres métalliques 31a, les traverses métalliques 31b, les rails de sièges 31c, les planchers 31d, etc., et
- les éléments structurels secondaires 32, qui comprennent les éléments transverses 32a, les supports de câbles électriques 32b, le support central 32c, etc.

Les éléments de jonction 4 du réseau ESN se déclinent également en deux catégories, à savoir :
- les éléments flexibles de jonction 41, telles des tresses métalliques, qui servent notamment à relier les éléments structurels primaires et secondaires du réseau ESN, et
- les éléments électromécaniques de jonction 42, tels des rivets, permettant notamment d'assembler ensemble deux éléments structurels du réseau ESN.

Néanmoins, tous les éléments métalliques du réseau ESN sont recouverts d'une peinture non conductrice permettant de protéger les éléments métalliques contre la corrosion et d'assurer la sécurité des personnes. En outre, un matériau d'interposition, tel un mastic, est régulièrement disposé au niveau des éléments électromécaniques de jonction de sorte à réduire l'usure des éléments structurels.

Pour chaque élément métallique du réseau ESN, il est donc nécessaire, au niveau des surfaces de contact, de décaper la peinture et éventuellement enlever le matériau d'interposition afin de mettre localement à nu l'élément métallique. Une telle opération, dite de métallisation, permet, d'assurer la continuité électrique entre les différents éléments métalliques formant le réseau ESN lors de l'assemblage de celui-ci.

Toutefois, il existe des risques que des résidus de peinture et/ou de matériau d'interposition subsistent sur les surfaces de contact des éléments métalliques. Or, la présence de tels résidus peut dégrader la qualité de la liaison entre les éléments métalliques et donc la conductivité électrique générale du réseau ESN.

La conductivité électrique des jonctions entre les différents éléments du réseau ESN, est généralement surveillée ou testée par le biais d'un appareil électronique, dit appareil de mesure, qui mesure la résistance électrique d'une zone déterminée du réseau ENS.

Un tel appareil de mesure comprend classiquement un générateur qui injecte, par le biais d'une pince, un signal électrique d'intensité donnée dans une boucle du réseau ESN.

La pince permet de mesurer l'intensité du signal électrique circulant dans la boucle du réseau ESN, ce qui permet à l'appareil de mesure de déterminer la valeur de la résistance de boucle représentative de la conductivité électrique de cette dernière.

Lorsque la continuité électrique dans la boucle n'est pas assurée, l'appareil émet un signal d'alerte.

### Principe général de l'invention

Le principe général de la technique proposée consiste à contrôler l'état d'usure, et donc de fonctionnement, de la pince d'un tel appareil de mesure de conductivité électrique de boucle, lorsqu'il est utilisé par exemple dans un aéronef comme décrit précédemment.

Ledit appareil de mesure est configuré pour induire un courant électrique dans la boucle par le biais de ladite pince, et pour obtenir la valeur du courant circulant dans la boucle de sorte à déterminer la conductivité électrique de ladite boucle.

Plus précisément, le procédé de contrôle de la pince mis en œuvre dans un tel appareil de mesure comprend les étapes suivantes :
- lors d'une utilisation de ladite pince, alimentation de ladite pince avec un signal électrique de test délivré par ledit appareil de mesure, puis mesure, au niveau de ladite pince, d'une valeur d'intensité du signal électrique de test, et
- comparaison entre la valeur mesurée d'intensité du signal électrique de test et une valeur de référence et si la différence entre lesdites valeurs mesurées et de référence est supérieure à un seuil prédéterminé, détection d'une usure de ladite pince.

Le procédé de l'invention permet ainsi de détecter l'éventuelle incapacité pour la pince d'injecter une intensité du courant donnée , ce qui indiquerait qu'elle est usée et doit être remplacée (l'utilisation d'une pince usée rendrait erronée la valeur de la résistance de boucle mesurée par l'appareil de mesure).

A chaque utilisation de la pince, après un nombre prédéterminé d'utilisations ou lorsque l'utilisateur le souhaite, l'état d'usure de celle-ci est contrôlé par l'appareil de mesure par le biais d'une procédure de test.

### Description de l'appareil de mesure

La figure 2 est une représentation schématique d'un appareil de mesure apte à mettre en œuvre les étapes (détaillées en figure 5) du procédé de contrôle de la pince couplée à un tel appareil, selon l'invention.

L'appareil de mesure 5 est relié à une pince 52 amovible qui vient enserrer un des éléments métalliques appartenant à la boucle 6 faisant l'objet d'une mesure de continuité électrique.

La pince 52 est reliée à un générateur d'alimentation 51 délivrant un courant électrique qui est transmis par induction électromagnétique de la pince 52 vers la boucle (courant C1), lorsque la pince 52 entoure un élément de la boucle 6. La même pince 52 recueille le courant électrique C2 circulant dans la boucle 6 par induction électromagnétique, ce qui permet à l'appareil de mesure 5 de déterminer la valeur de la résistance électrique de la boucle 6 représentative de la continuité électrique de cette dernière.

La pince 52 comprend :
- un circuit électrique 520, tel une bobine constituée d'un enroulement de fil conducteur, configuré pour injecter le courant C1 dans la boucle 6 du réseau ESN et pour mesurer l'intensité du courant C2 circulant dans cette même boucle 6,
- une mémoire de stockage 521 apte à mémoriser notamment des données d'identification (ou un identifiant) de la pince 52, et
- un capteur à effet Hall (non référencé) qui permet de vérifier que la pince est bien fermée (si le capteur détecte que la pince est ouverte, il y a arrêt de toutes les mesures).

Selon une mise en œuvre particulière, la mémoire de stockage 521 de la pince 52 stocke, outre l'identifiant de la pince, au moins une ou plusieurs des grandeurs suivantes : une valeur d'intensité d'un premier test dite de référence, la valeur de déphasage du premier test dite de référence entre le courant d'étalonnage injecté dans ladite pince et le courant recueilli par la pince lors de cet étalonnage, le nombre de spires de la pince, le coefficient du câble de la pince. Certaines de ces grandeurs permettent de calculer un "offset" lorsqu'on effectue une mesure ultérieure sur une boucle à l'aide de ladite pince 52. Il est à noter que le calcul de l'"offset" est facultatif et dépend du niveau de précision recherchée dans la mesure de la continuité électrique du réseau ESN.

Le premier test ou étalonnage de la pince 52 est effectué avant sa commercialisation, au moment de sa fabrication par exemple, en alimentant la pince 52 avec un signal électrique de référence de sorte à obtenir au moins une valeur d'intensité (d'un signal électrique) de référence et/ou de la valeur de déphasage de référence. Ces valeurs sont préférentiellement enregistrées dans la mémoire de stockage 521, mais peuvent être également stockées dans une mémoire de l'appareil 5 ou sur un serveur distant.

Par ailleurs, l'appareil de mesure 5 comprend :
- des moyens de lecture 53 des données d'identification, de la valeur d'intensité de référence et de la valeur de déphasage de référence, de la pince 52 mémorisées dans la mémoire de stockage 521 de cette dernière,
- une unité de traitement, prenant la forme d'un microprocesseur, 54 configurée pour calculer, sur la base des mesures effectuées par la pince 52, la valeur de la résistance de la boucle 6 du réseau ESN représentative de sa conductivité électrique et pour déterminer une éventuelle usure de la pince 52, par exemple à chacune des utilisations de cette dernière, après un nombre prédéterminé d'utilisations ou bien quand l'utilisateur le souhaite.
- une mémoire de stockage 55 comprenant une base de données associant des données d'identification (identifiants) uniques d'une ou plusieurs pinces à un historique de mesures effectuées (courant et/ou fréquence) lors des tests desdites pinces pouvant survenir à chaque utilisation de ces dernières, après un nombre prédéterminé d'utilisations ou bien encore lorsque l'utilisateur souhaite volontairement procéder à un test de la pince qu'il utilise. La base de données peut comprendre un indicateur d'usure (prenant la forme d'un bit qui peut prendre une valeur "0" ou "1") associé à l'identifiant de chaque pince.

Un tel appareil de mesure est ainsi configuré pour pouvoir procéder au contrôle de la pince qui est couplée à celui-ci, conformément à la technique proposée, en complément du calcul de résistance de boucle et de mesure de conductivité électrique.

Tel qu'illustré, l'appareil de mesure 5 permet de mesurer la résistance de la boucle 6, formée par les éléments métalliques joints aux points A, B, C et D, en disposant la pince 52 sur le pourtour d'un des éléments métalliques appartenant à cette boucle, à savoir l'élément métallique 51 dans cet exemple.

### Description du procédé de contrôle

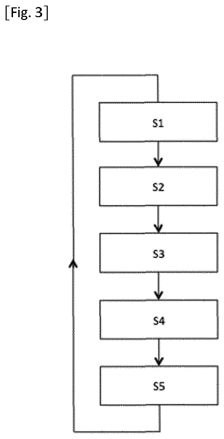

La figure 3 représente les étapes principales d'utilisation de l'appareil de mesure de conductivité électrique de boucle couplé à une pince.

Lors d'une première étape S1, l'appareil de mesure 5 est mis sous tension par l'utilisateur en vue de son utilisation.

Puis, lors de l'étape S2, la pince 52 (qui n'est pas encore reliée à la boucle) est couplée, par le biais d'un raccord (non représenté) à l'appareil de mesure 5, notamment aux moyens d'alimentation 51 et à l'unité de traitement 54.

Lors de l'étape S3, l'appareil de mesure 5 procède au contrôle de la pince 52 de manière à déterminer l'état de fonctionnement, et donc l'usure, de cette dernière.

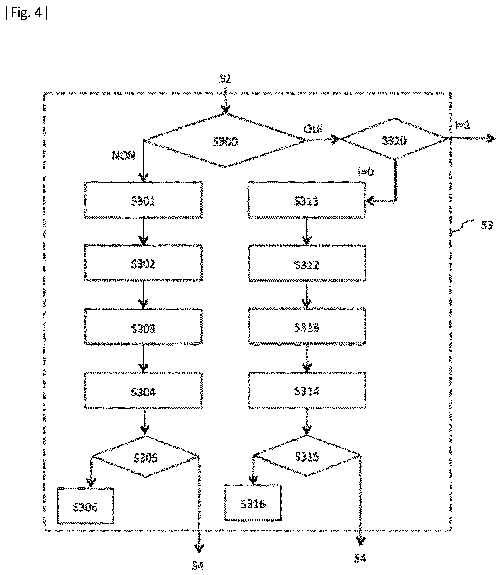

Les différentes étapes de cette phase de contrôle seront détaillées par la suite en relation avec la figure 4.

S'il est déterminé que la pince 52 n'est pas usée mais en bon état de fonctionnement, alors la pince 52 est reliée à une boucle d'un réseau conducteur électriquement et l'appareil de mesure détermine, par le biais de l'unité de traitement 54, la conductivité électrique de la boucle (étape S4).

Puis, lorsque la mesure de conductivité électrique est terminée, l'utilisateur procède à la mise hors tension (étape S5) de l'appareil de mesure 5.

Lorsque l'appareil de mesure 5 est hors tension, l'utilisateur peut, s'il le désire, découpler la pince 52. Ceci permet notamment de simplifier le rangement de l'appareil de mesure et de minimiser l'encombrement de celui-ci lorsqu'il n'est pas utilisé. Par ailleurs, il est possible de coupler une autre pince, différente de celle précédemment couplée, à l'appareil de mesure. Par exemple, il est possible de coupler des pinces dont la longueur des câbles et/ou les propriétés d'injection de courant sont différentes.

Lorsque l'appareil de mesure est à nouveau mis sous tension, les étapes décrites sont réitérées. On note toutefois que l'étape S3 de contrôle de la pince 52 peut être mise en œuvre à chacune des utilisations d'une pince avec l'appareil de mesure 5, après un nombre prédéterminé d'utilisations de la pince reliée à l'appareil ou bien quand l'utilisateur le souhaite.

La figure 4 illustre plus en détail cette étape S3 de contrôle de la pince visant à déterminer si cette dernière est usée (auquel cas elle doit être remplacée) ou non (auquel cas, elle est adaptée pour effectuer le calcul de la conductivité électrique d'une boucle par l'appareil de mesure, une fois la pince disposée autour d'un élément métallique appartenant à la boucle conformément à l'étape S4).

On rappelle que préalablement à une première utilisation de la pince, il est procédé à l'étalonnage de la pince avec un signal électrique de référence et à la mémorisation de données, dont une valeur d'intensité de référence, dans une mémoire, telle que la mémoire de la pince.

Pendant cette phase « d'apprentissage » ou d'auto-test, on alimente la pince 52 avec un signal électrique de référence variable dont la fréquence est choisie entre 100 et 200 Hz et la tension entre 0 et 20 V.

Cette phase est effectuée pas à pas jusqu'à la saturation de la pince, de sorte à déduire/mesurer l'intensité du courant qui circule dans la pince et le déphasage.

L'auto-test ou apprentissage permet de construire une table en tension, intensité et fréquence qui est caractéristique de la pince.

Ce sont tout ou partie de ces valeurs (au moins l'intensité) qui permettront d'évaluer l'usure de la pince par la suite.

Tel qu'illustré, le procédé de contrôle S3 débute par une étape d'identification S300 de la pince 52 qui est couplée à l'appareil de mesure 5.

Pour ce faire, l'étape d'identification S300 comprend une première sous-étape de lecture, par les moyens de lecture 53 de l'appareil de mesure 5, des données d'identification uniques de la pince 52. Les données d'identification uniques comprennent, par exemple, le numéro de série de la pince et/ou le numéro de série de la mémoire disposée dans la pince, et sont stockées dans la pince 52.

L'étape d'identification S300 comprend une deuxième sous-étape de recherche, dans la mémoire de stockage 55 de l'appareil de mesure 5, des données d'identification lues. Ceci permet de déterminer si la pince 52 est couplée pour la première fois à l'appareil de mesure 5 ou, au contraire, si la pince 52 a déjà été couplée à l'appareil de mesure 5.

Si la sous-étape de recherche est positive (sortie "OUI" de l'étape S300), c'est-à-dire que les données d'identification de la pince 52 sont enregistrées dans la mémoire de stockage 55 de l'appareil de mesure 5 (du fait que la pince 52 a déjà été utilisée avec le même appareil de mesure), alors une troisième sous-étape de lecture dans la mémoire de stockage 55 de la valeur de l'indicateur d'usure I associé à l'identifiant de la pince 52, est mise en œuvre.

A l'étape S310, il est déterminé si l'indicateur d'usure I de la pince 52 associé à l'identifiant de cette dernière dans la mémoire de stockage 55 indique ou non une usure de la pince 52.

A titre d'exemple, lorsque la valeur de l'indicateur d'usure I de la pince 52 est à "1", ce qui indique un état d'usure de la pince 52, une alarme est émise et l'utilisateur doit procéder au remplacement de la pince 52.

A contrario, lorsque la valeur de l'indicateur d'usure I de la pince 52 est égale à "0", ce qui indique un état de fonctionnement correct de la pince 52, aucune alarme n'est émise et le procédé de contrôle passe à l'étape S311 suivante.

À l'étape S311, l'appareil de mesure 5 alimente la pince 52 par le biais des moyens d'alimentation 51 avec un signal électrique de test.

Ce signal électrique de test est un signal électrique dont les paramètres sont prédéterminés. Plus précisément, le signal électrique de test est délivré, par les moyens d'alimentation 51, à par exemple une tension de 10V et à une fréquence de 200Hz. Ce signal électrique de test est délivré, par exemple pendant une durée de 5 secondes, de manière à ce que l'étape de mesure de ce signal (détaillée ci-après) puisse être réalisée.

Lors de l'étape S312, l'appareil 5 mesure, au niveau de la pince 52 par le biais du circuit électrique 520, une valeur de l'intensité électrique du signal électrique de test.

À l'étape S313, l'intensité mesurée est enregistrée dans la mémoire de stockage 55 de l'appareil de mesure 5 et est associée aux données d'identification uniques de la pince 52.

Ainsi, l'appareil de mesure 5 peut, lors d'une utilisation ultérieure de la pince 52 avec l'appareil de mesure 5, récupérer dans la mémoire de stockage 55 la valeur de l'intensité mesurée de la pince 52 par le biais des données d'identification de la pince 52.

Lors de l'étape S314 suivante, l'appareil de mesure lit la valeur d'intensité de référence de la pince 52 mémorisée dans la mémoire de stockage 521 de cette dernière et la compare avec la valeur mesurée d'intensité du signal électrique de test.

Si la valeur absolue de la différence calculée est supérieure à un seuil prédéterminé (étape S315), une usure de ladite pince 52 est détectée et l'indicateur d'usure de la pince 52 est mis à "1" dans la base de données de l'appareil de mesure 5 (étape S316). Un signal sonore et/ou visuel est délivré par l'appareil de mesure 5 (dans une variante, aucun signal n'est délivré ce qui indique l'usure de la pince).

Si la différence calculée est inférieure à un seuil prédéterminé (étape S315), un signal sonore et/ou visuel est délivré par l'appareil de mesure 5 indiquant le bon fonctionnement de la pince, et cette dernière peut être utilisée pour l'étape S4 décrite précédemment. En d'autres termes, l'utilisateur peut utiliser la pince 52 qui est couplée à l'appareil 5 pour déterminer la valeur de la conductivité électrique de boucle 6 d'un réseau conducteur électriquement.

Si la sous-étape de recherche de l'étape d'identification S300 est négative (sortie NON" de l'étape S300), c'est-à-dire que les données d'identification de la pince 52 ne sont pas enregistrées dans la mémoire de stockage 55 de l'appareil de mesure 5 (du fait que la pince 52 n'a pas été utilisée précédemment avec le même appareil de mesure), le procédé de contrôle passe à l'étape S301 suivante.

À l'étape S301, l'appareil de mesure 5 alimente la pince 52 par le biais des moyens d'alimentation 51 avec un signal électrique de test.

Ce signal électrique de test est un signal électrique dont les paramètres sont prédéterminés. Plus précisément, le signal électrique de test est délivré, par les moyens d'alimentation 51, à par exemple une tension de 10V et à une fréquence de 200Hz, par exemple. Ce signal électrique de test est en outre délivré, par exemple, pendant par une durée de 5 secondes, de manière à ce que l'étape de mesure de ce signal (détaillée ci-après) puisse être réalisée.

Lors de l'étape S302, l'appareil de mesure 5 mesure, au niveau de la pince 52 par le biais du circuit électrique 520, une valeur de l'intensité électrique du signal électrique de test.

À l'étape S303, l'intensité mesurée est enregistrée dans la mémoire de stockage 55 de l'appareil de mesure 5 et est associée aux données d'identification uniques de la pince 52.

Ainsi, l'appareil de mesure 5 peut, lors d'une utilisation ultérieure de la pince 52 avec l'appareil de mesure 5, récupérer dans la mémoire de stockage 55 la valeur de l'intensité mesurée de la pince 52 par le biais des données d'identification de la pince 52.

Lors de l'étape S304 suivante, l'appareil de mesure lit la valeur d'intensité de référence de la pince 52 mémorisée dans la mémoire de stockage 521 de cette dernière et la compare avec la valeur mesurée d'intensité du signal électrique de test.

Si la valeur absolue de la différence calculée est supérieure à un seuil prédéterminé (étape S305), une usure de ladite pince 52 est détectée et l'indicateur d'usure de la pince 52 est mis à "1" dans la base de données de l'appareil de mesure 5 (étape S306). Un signal sonore et/ou visuel est délivré par l'appareil de mesure 5 (dans une variante, aucun signal n'est délivré ce qui indique l'usure de la pince).

Si la différence calculée est inférieure à un seuil prédéterminé (étape S305), un signal sonore ou visuel est délivré par l'appareil de mesure 5 indiquant le bon fonctionnement de la pince, et cette dernière peut être utilisée pour l'étape S4 décrite précédemment. En d'autres termes, l'utilisateur peut utiliser la pince 52 qui est couplée à l'appareil 5 pour déterminer la valeur de la conductivité électrique de boucle 6 d'un réseau conducteur électriquement.

Ainsi, si le résultat de la comparaison dépasse un seuil prédéterminé, cela signifie que la pince 52 n'est plus apte à injecter l'intensité du courant délivré par le générateur de l'appareil de mesure 5.

Selon une mise en œuvre préférentielle, le seuil prédéterminé correspond à 23% de la valeur d'intensité de référence stockée dans la pince 52.

Une telle valeur de seuil permet d'assurer la détection d'une pince usée tout en minimisant le risque qu'une pince en bon état soit assimilée à une pince usée.

Pour rappel, le contrôle de la pince 52 par l'appareil de mesure 5 lors de l'étape S3 peut survenir à chaque utilisation de la pince 52, après un nombre prédéterminé d'utilisations de cette dernière ou bien encore lorsque l'utilisateur souhaite volontairement procéder à un test de la pince.

Dans un mode de réalisation particulier, la mémoire de stockage 521 de la pince 52 comprend un indicateur d'usure (pouvant prendre une valeur "0" ou "1") qui peut être lu par l'appareil de mesure lors de la connexion de ce dernier avec la pince. Cette valeur peut être changée de "0" à "1" (la valeur "1" indiquant une usure de la pince) par l'appareil de mesure lorsqu'au cours d'un test, une usure de la pince est déterminée par cet appareil de mesure.

Dans une variante, la mémoire de stockage 521 de la pince 52 comprend trois statuts différents, à savoir un statut "ok" indiquant un état de fonctionnement correct de la pince, un statut "test à faire" indiquant que la pince doit être étalonnée, et un statut "pince mauvaise » indiquant une usure de la pince.

La mémoire de stockage 521 de la pince 52 peut également stocker le nombre de cycles d'utilisation de la pince.

Selon une mise en œuvre particulière, le signal électrique de test est un signal sinusoïdal délivré à une tension de 10V et à une fréquence de 200Hz pendant une durée de 5 secondes. Un tel paramétrage du signal électrique de test permet d'assurer le contrôle du bon fonctionnement de la pince tout en évitant d'endommager celle-ci, et donc d'accélérer son usure

Plus généralement, le signal électrique de test est un signal sinusoïdal délivré à une tension comprise entre 5 et 15V, de préférence entre 7 et 12V, et une fréquence comprise entre 50 et 400Hz, de préférence entre 75 et 300Hz, de préférence encore entre 100 et 200Hz.

Néanmoins, d'autres tensions et/ou fréquences peuvent être envisagées.

Dans un mode de réalisation particulier, les paramètres (tension, fréquence et durée de délivrance) du signal électrique de test sont déterminés en fonction du type de pince à tester.

Par exemple, une pince d'un premier type, est contrôlée avec un signal électrique de test de 5V à une fréquence de 100Hz tandis qu'une pince d'un deuxième type, est contrôlée avec un signal électrique de test de 10V à une fréquence de 200Hz. Ceci permet notamment de contrôler l'usure d'une pince en appliquant un signal électrique de test le plus proche possible de ses propriétés nominales d'utilisation.

Dans le mode de réalisation décrit précédemment, la caractéristique de la pince qui est contrôlée est l'intensité du signal électrique de test.

Toutefois, dans une variante, la caractéristique mesurée et contrôlée peut être la fréquence du signal électrique de test.

Dans une autre variante, l'intensité et la fréquence du signal électrique de test sont toutes deux mesurées et contrôlées de sorte à améliorer la précision du procédé de contrôle.

Toutefois, la mesure et le contrôle de toute autre caractéristique du signal électrique de test peut être envisagée à condition que la caractéristique retenue permette de réaliser un contrôle fiable de l'usure de la pince.

Dans le mode de réalisation décrit, le seuil prédéterminé correspond à 23% de la valeur d'intensité du signal électrique de référence.

Toutefois, dans d'autres modes de réalisation alternatifs, le seuil peut être compris entre 10 et 60%, de préférence entre 15 et 45%, de préférence encore entre 20 et 30%, de la valeur d'intensité du signal électrique de référence.

Il est à noter que le procédé de contrôle peut comprendre une étape d'enregistrement, dans la mémoire de stockage de l'appareil et/ou de la pince, de la différence calculée entre la valeur d'intensité de référence de la pince et la valeur mesurée d'intensité du signal électrique de test et/ou de la valeur mesurée d'intensité du signal électrique de test.

La mémoire de stockage de l'appareil de mesure peut en outre mémoriser des alertes pour chaque pince dès lors que la différence calculée entre la valeur d'intensité de référence de la pince et la valeur mesurée d'intensité du signal électrique de test dépasse le seuil prédéterminé.

Le procédé de contrôle peut, par ailleurs, comprendre une étape de transmission, par le biais de moyens de communication sans fil par exemple, des données enregistrées, dans l'espace de stockage de l'appareil de mesure, vers un terminal distant. Une telle étape permet notamment d'assurer le suivi et la traçabilité de l'usure des pinces utilisées.

Par ailleurs, le procédé de test de la pince peut être amorcé automatiquement postérieurement au couplage de la pince avec l'appareil de mesure. Un tel mode de fonctionnement permet de s'assurer que le contrôle de la pince est effectué à chaque utilisation de l'appareil de mesure. Toutefois, le procédé de test de la pince peut être déclenché par l'utilisateur, par le biais d'un bouton situé sur l'appareil, par exemple. Un tel mode de fonctionnement permet à l'utilisateur de réaliser le contrôle d'une pince lorsqu'il le désire.

La pince peut être configurée pour déclencher, lorsqu'elle est couplée à un appareil de mesure, un test ou diagnostic après un certain nombre d'utilisations de ladite pince comptabilisées dans la mémoire de cette dernière.

Il peut être prévu que l'appareil de mesure indique l'usure de la pince couplée à l'appareil dès lors que le nombre d'utilisations de ladite pince est supérieur à un nombre prédéterminé, indépendamment du résultat de la comparaison entre la valeur d'intensité de référence de la pince et la valeur mesurée d'intensité du signal électrique de test.

Bien évidemment, la technique proposée n'est pas limitée aux modes de réalisation décrits précédemment et fournis uniquement à titre d'exemple.

## Revendications

1. Procédé de contrôle (S3) d'une pince (52) d'un appareil de mesure (5) de conductivité électrique de boucle (6), ledit appareil de mesure (5) étant configuré pour induire un courant électrique dans la boucle (6) par le biais de ladite pince (52), et pour obtenir la valeur du courant circulant dans la boucle (6) de sorte à déterminer la conductivité électrique de ladite boucle (6), ledit procédé comprenant les étapes suivantes :
- lors d'une utilisation de ladite pince (52), alimentation (S311) de ladite pince (52) avec un signal électrique de test délivré par ledit appareil de mesure (5), puis mesure (S312), au niveau de ladite pince (52), d'une valeur d'intensité du signal électrique de test, et
- comparaison entre la valeur mesurée d'intensité du signal électrique de test et une valeur d'intensité de référence, et, si la différence entre lesdites valeurs comparées est supérieure à un seuil prédéterminé, détection d'une usure de ladite pince (52).

2. Procédé de contrôle (S3) selon la revendication 1, **caractérisé en ce qu'**il comprend en outre, lors de ladite utilisation de ladite pince (52), une étape de lecture (S301) par ledit appareil de mesure (5) de données d'identification de ladite pince (52) mémorisées dans une mémoire de stockage (521) de ladite pince (52), et une étape d'enregistrement (S304) desdites données d'identification lues et de la valeur mesurée d'intensité du signal électrique de test dans une mémoire de stockage (55) dudit appareil de mesure (5).

3. Procédé de contrôle (S3) selon la revendication 1 ou 2, **caractérisé en ce qu'**il comprend une étape de lecture (S314) dans ladite mémoire de stockage (521) de ladite pince (52) de la valeur d'intensité de référence.

4. Procédé de contrôle (S3) selon l'une des revendications 1 à 3, **caractérisé en ce qu'**il comprend, préalablement à une première utilisation de ladite pince (52), une étape d'étalonnage de la pince (52) en alimentant la pince (52) avec un signal électrique de référence de sorte à obtenir au moins la valeur d'intensité de référence de la pince (52).

5. Procédé de contrôle (S3) selon l'une des revendications 1 à 4, **caractérisé en ce qu'**il comprend une étape de mémorisation d'au moins ladite valeur d'intensité de référence dans ladite mémoire de stockage (521) de ladite pince (52).

6. Procédé de contrôle (S3) selon la revendication 4, **caractérisé en ce que** l'étape d'étalonnage de la pince (52) consiste à alimenter la pince (52) avec ledit signal électrique de référence variable de sorte à obtenir une table de référence en tension, intensité et fréquence caractéristique de ladite pince (52).

7. Procédé de contrôle (S3) selon l'une quelconque des revendications 1 à 6, **caractérisé en ce qu'**il comprend en outre une étape de signalisation (S316) sonore et/ou visuelle, par ledit appareil de mesure (5), d'une usure de ladite pince (52).

8. Procédé de contrôle (S3) selon l'une quelconque des revendications 1 à 7, **caractérisé en ce que** ledit seuil prédéterminé est compris entre 10 et 60% de ladite valeur d'intensité de référence.

9. Appareil de mesure (5) de conductivité électrique de boucle configuré pour induire un courant électrique dans la boucle (6) par le biais d'une pince (52), et pour obtenir, par le biais de ladite pince (52), la valeur du courant circulant dans la boucle (6) de sorte à déterminer la conductivité électrique de ladite boucle (6), ledit appareil de mesure (5) comprenant :
- des moyens d'alimentation (51) de ladite pince (52) avec un signal électrique de test lors d'une utilisation de ladite pince (52),
- des moyens de mesure (520), au niveau de ladite pince (52), d'une valeur d'intensité du signal électrique de test,
- des moyens (54) de comparaison entre la valeur mesurée d'intensité du signal électrique de test, et une valeur d'intensité de référence,
- des moyens de détection d'une usure de ladite pince (52) lorsque la différence calculée entre lesdites valeurs comparées est supérieure à un seuil prédéterminé.

10. Appareil de mesure (5) selon la revendication 9, **caractérisé en ce que** ladite pince (52) comprend une mémoire de stockage (521) d'une valeur d'intensité de référence, ladite valeur étant destinée à être lue par ledit appareil de mesure (5) pour détecter une usure éventuelle de ladite pince (52).

11. Appareil (5) selon la revendication 10, **caractérisée en ce que** ladite mémoire de stockage (521) de ladite pince (52) stocke en outre au moins une des informations suivantes :
- des données d'identification de ladite pince (52) ;
- un indicateur d'usure de ladite pince (52) ;
- un nombre d'utilisations de ladite pince (52) ;
- une valeur de déphasage de référence entre un courant d'étalonnage injecté dans ladite pince et un courant délivré par la pince;
- le nombre de spires de la pince ;
- un coefficient d'un câble de la pince permettant de relier la pince audit appareil de mesure (5).

## Patentansprüche

1. Verfahren zur Kontrolle (S3) einer Zange (52) eines Geräts (5) zur Messung der elektrischen Leitfähigkeit einer Schleife (6), wobei das Messgerät (5) eingerichtet ist, um über die Zange (52) einen elektrischen Strom in der Schleife (6) zu induzieren und um den Wert des in der Schleife (6) fließenden Stroms zu erfassen, so dass die elektrische Leitfähigkeit der Schleife (6) bestimmt wird, wobei das Verfahren die folgenden Schritte umfasst:
- bei einer Verwendung der Zange (52), Speisung (S311) der Zange (52) mit einem elektrischen Testsignal, das von dem Messgerät (5) ausgegeben wird, dann Messung (S312) eines Werts der Stärke des elektrischen Testsignals an der Zange (52), und
- Vergleich zwischen dem gemessenen Wert der Stärke des elektrischen Testsignals und einem Referenz-Stärkewert und, wenn die Differenz zwischen den verglichenen Werten größer als ein vorbestimmter Schwellenwert ist, Detektion eines Verschleißes der Zange (52).

2. Verfahren zur Kontrolle (S3) nach Anspruch 1, **dadurch gekennzeichnet, dass** es ferner bei der Verwendung der Zange (52) einen Schritt des Lesens (S301) durch das Messgerät (5) von Daten zur Identifizierung der Zange (52) umfasst, welche in einem Speicher (521) der Zange (52) gespeichert sind, und einen Schritt des Aufzeichnens (S304) der gelesenen Identifizierungsdaten und des gemessenen Werts der Stärke des elektrischen Testsignals in einem Speicher (55) des Messgeräts (5).

3. Verfahren zur Kontrolle (S3) nach Anspruch 1 oder 2, **dadurch gekennzeichnet, dass** es einen Schritt des Lesens (S314) des Referenz-Stärkewerts in dem Speicher (521) der Zange (52) umfasst.

4. Verfahren zur Kontrolle (S3) nach einem der Anspruche 1 bis 3, **dadurch gekennzeichnet, dass** es vor einer ersten Verwendung der Zange (52) einen Schritt der Kalibrierung der Zange (52) umfasst, indem die Zange (52) mit einem elektrischen Referenzsignal gespeist wird, um mindestens den Referenz-Stärkewert der Zange (52) zu erhalten.

5. Verfahren zur Kontrolle (S3) nach einem der Anspruche 1 bis 4, **dadurch gekennzeichnet, dass** es einen Schritt der Speicherung von mindestens dem Referenz-Stärkewert in dem Speicher (521) der Zange (52) umfasst.

6. Verfahren zur Kontrolle (S3) nach Anspruch 4, **dadurch gekennzeichnet, dass** der Schritt der Kalibrierung der Zange (52) darin besteht, die Zange (52) mit dem variablen elektrischen Referenzsignal zu speisen, um eine Referenztabelle zu charakteristischer Spannung, Intensität und Frequenz der Zange (52) zu erhalten.

7. Verfahren zur Kontrolle (S3) nach einem beliebigen der Anspruche 1 bis 6, **dadurch gekennzeichnet, dass** es ferner einen Schritt der akustischen und/oder optischen Signalisierung (S316) eines Verschleißes der Zange (52) durch das Messgerät (5) umfasst.

8. Verfahren zur Kontrolle (S3) nach einem beliebigen der Anspruche 1 bis 7, **dadurch gekennzeichnet, dass** der vorbestimme Schwellenwert zwischen 10 und 60% des Referenz-Stärkewerts liegt.

9. Gerät (5) zur Messung der elektrischen Leitfähigkeit einer Schleife, das eingerichtet ist, um über eine Zange (52) einen elektrischen Strom in der Schleife (6) zu induzieren und um über die Zange (52) den Wert des in der Schleife (6) fließenden Stroms zu erfassen, um die elektrische Leitfähigkeit der Schleife (6) zu bestimmen, wobei das Messgerät (5) umfasst:
- Mittel (51) für die Speisung der Zange (52) mit einem elektrischen Testsignal bei einer Verwendung der Zange (52),
- Mittel (520) für die Messung eines Werts der Stärke des elektrischen Testsignals an der Zange (52),
- Mittel (54) für den Vergleich zwischen dem gemessenen Wert der Stärke des elektrischen Testsignals und einem Referenz-Stärkewert,
- Mittel für die Detektion eines Verschleißes der Zange (52), wenn die berechnete Differenz zwischen den verglichenen Werten größer als ein vorbestimmter Schwellenwert ist.

10. Messgerät (5) nach Anspruch 9, **dadurch gekennzeichnet, dass** die Zange (52) einen Speicher (521) zur Speicherung eines Referenz-Stärkewerts umfasst, wobei der Wert dazu vorgesehen ist, von dem Messgerät (5) gelesen zu werden, um einen eventuellen Verschleiß der Zange (52) zu detektieren.

11. Gerät (5) nach Anspruch 10, **dadurch gekennzeichnet, dass** der Speicher (521) der Zange (52) ferner mindestens eine der folgenden Informationen speichert:
- Identifikationsdaten der Zange (52);
- einen Indikator für den Verschleiß der Zange (52);
- eine Anzahl von Verwendungen der Zange (52);
- einen Referenz-Phasenverschiebungswert zwischen einem in die Zange eingespeisten Kalibrierungsstrom und einem von der Zange abgegebenen Strom;
- die Anzahl von Windungen der Zange;
- einen Koeffizienten eines Zangenkabels für die Verbindung der Zange mit dem Messgerät (5).

## Claims

1. Method (S3) for controlling a clamp (52) of a device (5) for measuring electrical conductivity of a loop (6), said measuring device (5) being configured to induce an electric current in the loop (6) by means of said clamp (52), and to obtain the value of the current circulating in the loop (6) so as to determine the electrical conductivity of said loop (6), said method comprising the following steps:
- during a use of said clamp (52), the supply (S311) of said clamp (52) with an electrical test signal delivered by said measuring device (5), then the measurement (S312), at said clamp (52), of an intensity value of the electrical test signal, and
- comparison between the measured intensity value of the electrical test signal and a reference intensity value, and, if the difference between said compared values is higher than a predetermined threshold, detection of wear on said clamp (52).

2. Control method (S3) according to claim 1, **characterised in that** it further comprises, during said use of said clamp (52), a step (S301) of reading, by said measuring device (5), of data identifying said clamp (52) stored in a storage memory (521) of said clamp (52), and a step (S304) of recording said identification data read and the measured intensity value of the electrical test signal in a storage memory (55) of said measuring device (5).

3. Control method (S3) according to claim 1 or 2, **characterised in that** it comprises a step (S314) of reading the reference intensity value in said storage memory (521) of said clamp (52).

4. Control method (S3) according to one of claims 1 to 3, **characterised in that** it comprises, prior to a first use of said clamp (52), a step of calibrating the clamp (52) by supplying the clamp (52) with a reference electrical signal so as to obtain at least the reference intensity value of the clamp (52).

5. Control method (53) according to one of claims 1 to 4, **characterised in that** it comprises a step of storing at least said reference intensity value in said storage memory (521) of said clamp (52).

6. Control method (S3) according to claim 4, **characterised in that** the step of calibrating the clamp (52) consists of supplying the clamp (52) with said variable reference electrical signal so as to obtain a reference table of voltage, intensity and frequency characteristic of said clamp (52).

7. Control method (S3) according to any one of claims 1 to 6, **characterised in that** it further comprises a step (S316) of audible and/or visual signalling, by said measuring device (5), of wear on said clamp (52).

8. Control method (S3) according to any one of claims 1 to 7, **characterised in that** said predetermined threshold lies between 10 and 60% of said reference intensity value.

9. Device (5) for measuring loop electrical conductivity, configured to induce an electric current in the loop (6) by means of a clamp (52), and to obtain, by means of said clamp (52), the value of the current circulating in the loop (6) so as to determine the electrical conductivity of said loop (6), said measuring device (5) comprising:
- means (51) for supplying said clamp (52) with an electrical test signal during a use of said clamp (52),
- means (520) for measuring, at said clamp (52), an intensity value of the electrical test signal,
- means (54) for comparison between the measured intensity value of the electrical test signal and a reference intensity value,
- means for detecting wear on said clamp (52) when the calculated difference between said compared values is higher than a predetermined threshold.

10. Measuring device (5) according to claim 9, **characterised in that** said clamp (52) comprises a memory (521) for storing a reference intensity value, said value being intended to be read by said measuring device (5) in order to detect any wear on said clamp (52).

11. Device (5) according to claim 10, **characterised in that** said storage memory (521) of said clamp (52) furthermore stores at least one of the following items of information:
- identification data for said clamp (52);
- an indicator of wear on said clamp (52);
- a number of uses of said clamp (52);
- a reference value of phase difference between a calibration current injected into said clamp and a current delivered by the clamp;
- the number of turns on the clamp;
- a coefficient of a cable of the clamp for connecting the clamp to said measuring device (5).
